# EUROPÄISCHE PATENTSCHRIFT

(11) **EP 0 510 311 B1**
(45) Veröffentlichungstag und Bekanntmachung des Hinweises auf die Patenterteilung: **21.05.1997**
(21) Anmeldenummer: 92102115.0
(22) Anmeldetag: 08.02.1992
(51) Int. Cl.: G01R 15/06, H01F 38/34, G01R 15/14

(54) **Strom- und Spannungswandler für eine metallgekapselte, gasiolierte Hochspannungsanlage**
Current and voltage transformer for a metal encapsulated, gas insulated high-voltage installation
Transformateur de courant et de tension pour une installation haute tension à encapsulation métallique et à gaz isolant

(30) Priorität: 22.04.1991 CH 1195/91
(43) Veröffentlichungstag der Anmeldung: 28.10.1992
(73) Patentinhaber: ASEA BROWN BOVERI AG, 5400 Baden (CH)
(72) Erfinder: Baumgartner, Rudolf, Dr., CH-5412 Gebenstorf (CH); Haffner, Ken Yves, CH-5400 Baden (CH); Hägeli, Heinz, CH-5424 Unterehrendingen (CH); Kaczkowski, Andrzej, Dr., CH-5303 Würenlingen (CH)

(56) Entgegenhaltungen:
- EP-A- 0 172 634
- DE-A- 3 544 508
- FR-A- 2 230 052
- FR-A- 2 255 604
- IEE PROCEEDINGS B. ELECTRICAL POWER APPLICATIONS Bd. 130, Nr. 5, September 1983, STEVENAGE GB Seiten 360 - 363 PETTINGA ET AL. 'A POLYPHASE 500 KA CURRENT MEASURING SYSTEM...'

## Beschreibung

### TECHNISCHES GEBIET

Bei der Erfindung wird ausgegangen von einem Strom- und Spannungswandler nach dem Oberbegriff von Patentanspruch 1.

### STAND DER TECHNIK

Die Erfindung nimmt dabei Bezug auf einen Stand der Technik, wie er sich beispielsweise aus DE-A1-2325441 ergibt. Ein in Fig.1 dieser Patentveröffentlichung dargestellter und zum Einbau in eine metallgekapselte, gasisolierte Schaltanlage bestimmter Messwandler enthält ein an einem Montageansatz elektrisch isoliert befestigtes metallenes Rohr sowie Stromwandlerkerne mit aufgebrachten Sekundärwicklungen. Das metallene Rohr und die von ihm getragenen Stromwandlerkerne mit den aufgebrachten Sekundärwicklungen sind koaxial mit einem Stromleiter der Anlage im Inneren der Metallkapselung angeordnet. Das metallene Rohr bildet mit dem Stromleiter den Oberspannungskondensator eines kapazitiven Teilers, an dessen Ausgang ein Signal ansteht, welches der am Stromleiter anliegenden Spannung entspricht. An den Sekundärwicklungen können Signale abgegriffen werden, welche dem im Stromleiter fliessenden Strom entsprechen. Die Stromwandlerkerne weisen grosse Abmessungen auf und enthalten zudem überwiegend spezifisch schweres, ferromagnetisches Material. Daher beansprucht der Strom- und Spannungswandler nach dem Stand der Technik nicht nur viel Raum, sondern sollte aufgrund seines hohen Gewichtes zudem besonders stabil ausgebildet sein.

In EP-A1-0 172 634, insbesondere Figuren 7 bzw. 8, sind kombinierte Strom- und Spannungswandler beschrieben, bei denen eine Wicklung 150 bzw. 168 eines Stromwandlers elektrisch abgeschirmt in einem auf Erdpotential befindlichen Gehäuse 140, 152 bzw. in einem teilweise auf unbestimmtem Potential (Gehäuseteil 160) und teilweise auf Erdpotential (Gehäuseteil 166) befindlichen Gehäuse 160, 166 angeordnet ist.

Aus DE-A1-35 44 508 ist ein kombinierter Strom- und Spannungswandler zum Einbau in einen gasisolierten metallgekapselten Leiter 10 bekannt. Dieser Wandler weist als Stromsensor eine Rogowskispule mit kreisringförmigem Querschnitt auf. Eine Wicklung 1 dieser Spule ist auf einem Kunststoffträger 2 aufgebracht und ist von einer nichtmagnetischen, sich in elektrisch isolierender Weise überlappenden und als elektrische Abschirmung sowie als Elektrode zur kapazitiven Spannungsmessung wirkenden Metallfolie 3 umgeben. Die Spule ist in einer koaxial um den Leiter 10 geführten und mit einer Isolierschicht 13 versehenen Nut 12 der Metallkapselung 11 angeordnet. Bedingt durch den kreisförmigen Querschnitt kann die Spule nicht ohne erhebliche Beeinträchtigung des Isolationsabstandes in die Kapselung eingebaut werden und können Unsymmetrien im Magnetfeld des zu messenden Stroms sowie der Einfluss unerwünschter Fremdfelder die Messgenauigkeit beeinträchtigen.

Pettinga J.A.J. und Siersema J.: "A polyphase 500 kA current measuring system with Rogowski coils", IEE Proceedings, Vol.130, Pt.B, No.5, September 1983, S.360-363, insbesondere S.360 (g), beschreiben eine Rogowskispule, bei der der Einfluss magnetischer Fremdfelder auf die in der Rogowskispule induzierte Spannung durch Metallabschirmungen reduziert wird, die um die Spule herum angeordnet werden.

### KURZE DARSTELLUNG DER ERFINDUNG

Der Erfindung, wie sie in Patentanspruch 1 angegeben ist, liegt die Aufgabe zugrunde, einen Strom- und Spannungswandler für metallgekapselte, gasisolierte Hochspannungsanlagen anzugeben, welcher geringe Abmessungen aufweist und problemlos an beliebigen Stellen in die Anlage eingebaut werden kann.

Der Strom- und Spannungswandler nach der Erfindung zeichnet sich dadurch aus, dass er gegenüber dem Durchmesser der Metallkapselung eine vernachlässigbar geringe, im Bereich der Kapselungswand liegende Abmessung in Richtung des Kapselungsdurchmessers aufweist. Er kann daher ohne wesentliche Beeinträchtigung des Isolationsabstandes nahezu an beliebigen Stellen ins Innere der Kapselung eingebaut werden.

Ein bevorzugtes Ausführungsbeispiel der Erfindung und die damit erzielbaren weiteren Vorteile werden nachfolgend anhand von Zeichnungen näher erläutert.

### KURZE BESCHREIBUNG DER ZEICHNUNGEN

In der Zeichnung sind Ausführungsbeispiele der Erfindung schematisch dargestellt, und zwar zeigt:
- Fig.1: eine Aufsicht auf einen zentral geführten Schnitt durch ein Teil einer metallgekapselten, gasisolierten Hochspannungsschaltanlage mit Strom- und Spannungswandlern nach der Erfindung, und
- Fig.2: eine Aufsicht auf einen durch Umrandung markierten Teil eines Strom- und Spannungswandlers nach Fig.1.

### WEGE ZUR AUSFÜHRUNG DER ERFINDUNG

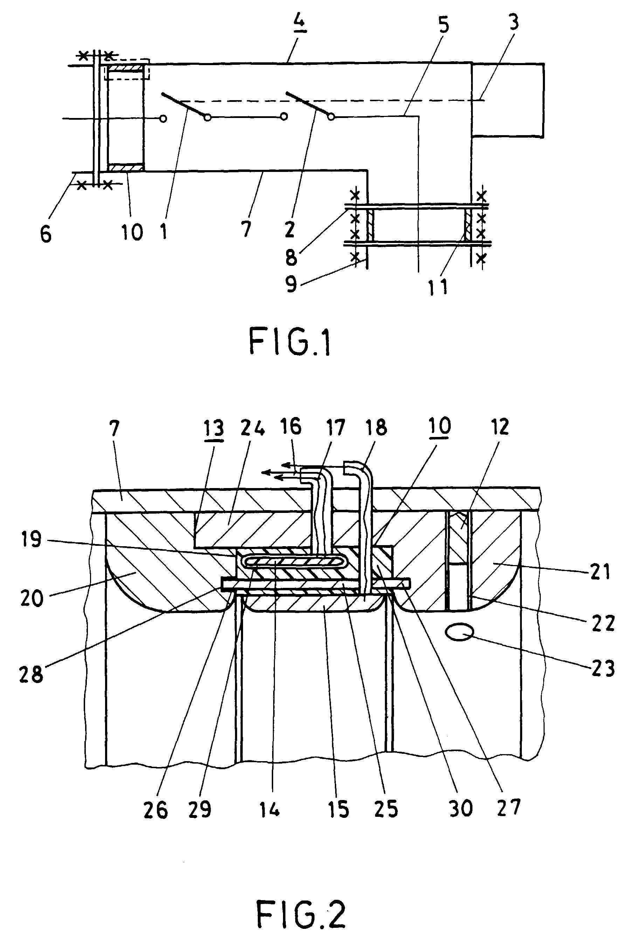

In Fig.1 ist ein einen Leistungsschalter mit Schaltstellen 1, 2 und einem Antrieb 3 enthaltender Teil einer metallgekapselten, gasisolierten Hochspannungsschaltanlage dargestellt. Hierbei ist die auf Erdpotential befindliche und mit dem Bezugszeichen 4 bezeichnete rohrförmige Metallkapselung mit einem Isoliergas, wie insbesondere SF₆, von einigen Bar Druck gefüllt. Im Inneren der Metallkapselung 4 ist ein längs deren Rohrachse erstreckter Stromleiter 5 angeordnet. Dieser Stromleiter ist auf nicht dargestellten, zwischen Kapselungsabschnitten 6,7 bzw. 7,8 bzw. 8,9 eingeflanschten und vorzugsweise eine Isoliergasabschottung bewirkenden Isolatoren abgestützt. Im Inneren der Metallkapselung 4 sind Strom- und Spannungssensoren von Strom- und Spannungswandlern 10, 11 vorgesehen. Diese Sensoren umgeben den Stromleiter 5 konzentrisch und weisen mit den sie haltenden Teilen der Metallkapselung 4, d.h. einem Teil des Kapselungsabschnittes 7 bzw. dem Kapselungsabschnitt 8, gleiche Achse auf. Enthält die Metallkapselung 1 mehr als einen Stromleiter, so umgeben die Sensoren der Strom- und Spannungswandler den zugeordneten Stromleiter zwar konzentrisch, weisen dann jedoch nicht die gleiche Achse auf wie die Metallkapselung.

Die in nicht extra hervorgehobene Tragkörper integrierten Sensoren der Strom- und Spannungswandler 10, 11 weisen gegenüber dem Durchmesser der rohrförmigen Metallkapselung 4 quer zur Rohrachse lediglich eine geringe Abmessung auf. Daher können die Sensoren, wie etwa diejenigen des Strom- und Spannungswandlers 10, ohne wesentliche Beeinträchtigung des Isolationsabstandes nahezu an jedem beliebigen Ort in die Metallkapselung 4 eingeschoben und durch geeignete Massnahmen, wie etwa durch Verklemmen oder Verschrauben, fixiert werden. Es ist aber auch - wie bei den Sensoren des Strom- und Spannungswandlers 11 dargestellt - möglich, den Tragkörper zwischen zwei Flanschen der Metallkapselung 4 einzubauen und mittels Verschraubungen gasdicht zu fixieren. Hierbei kann - wie aus Fig.1 ersichtlich ist - der fixierte Tragkörper in einen Kapselungsabschnitt integriert sein. Gegebenenfalls kann aber ein den Stromleiter 5 stützender und zwischen zwei Flanschen befestigter Isolator zur Halterung der Sensoren eingesetzt werden.

Aus Fig.2 sind Aufbau und Anordnung des Strom- und des Spannungssensors des Strom- und Spannungswandlers 10 zu erkennen. Das in dieser Figur vergrössert dargestellte Teil des Strom- und Spannungswandlers 1o enthält im wesentlichen einen - beispielsweise durch radial nach aussen gegen das Kapselungsteil 7 geführte Schrauben 12 - in der Metallkapselung verklemmten, ringförmigen Tragkörper 13, eine torusförmig gewickelte ringförmige Spule 14 als Stromsensor, eine hohlzylindrische Messelektrode 15 als Spannungssensor sowie gasdicht aus der Metallkapselung zu einer nicht dargestellten Auswerteelektronik des Strom- und Spannungswandlers geführte, abgeschirmte Signalleitungen 16, 17 und 18. In dieser Auswerteelektronik werden aus den von den Sensoren abgegebenen Signalen Messwerte gebildet, die dem im Stromleiter 5 fliessenden Strom bzw. der am Stromleiter 5 anliegenden Spannung entsprechen.

Der Tragkörper 13 enthält einen den Stromleiter 5 ringförmig umgebenden Raum 19, in dem die Spule 14 angeordnet ist. Der Raum 19 ist an seinen beiden Stirnseiten von zwei den Stromleiter 5 wulstförmig umgebenden Abschirmelektroden 20, 21 begrenzt. Die Abschirmelektrode 21 weist verschliessbare Bohrungen 22, 23 zur Aufnahme der Schrauben 12 sowie einen auf der Innenfläche des Kapselungsteils 7 aufliegenden, ringförmigen Ansatz 24 auf, welcher unter Bildung des Tragkörpers 13 in die Abschirmelektrode 20 eingepasst ist. Der Ansatz 24 begrenzt den ringförmigen Raum 19 an seiner der Metallkapselung zugewandten Mantelfläche, wohingegen der Raum 19 an seiner dem Stromleiter 5 zugewandten Mantelfläche von einer flächenhaften, ringförmigen Abschirmelektrode 25 begrenzt ist. Die eine Stirnseite der Abschirmelektroden 25 ist in elektrisch leitender Weise an der Abschirmelektrode 21 und deren gegenüberliegende Stirnseite in elektrisch isolierender Weise an der Abschirmelektrode 20 gehalten. Die Abschirmelekroden 20, 21 und 25 bestehen bevorzugt aus dem gleichen Material wie die Metallkapselung, beispielsweise aus Aluminium, und befinden sich auf dem gleichen elektrischen Potential wie die Metallkapselung. Hierdurch wird der Raum 19 gegenüber dem Einfluss von elektrischen Störfeldern abgeschirmt, und werden von der Spule 14 daher beim Messen in der Anlage unter Betriebsbedingungen nahezu fehlerfreie Signale abgegeben.

Eine besonders gute Abschirmung der Spule 14 wird erreicht, wenn mindestens eine der beiden Abschirmelektroden 20, 21 eine den Stromleiter 5 ringförmig umgebende Materialausnehmung aufweist, in die eine der beiden Stirnseiten der Abschirmelektrode 25 eingelassen ist. Besonders bewährt hat es sich hierbei sowohl in der Abschirmelektrode 20 als auch in der Abschirmelektrode 21 jeweils eine als ringförmige Nut 26, 27 ausgebildete und in Richtung der Rohrachse erstreckte Materialausnehmung einzulassen und in der einen Materialausnehmung, z.B. der Nut 26, die etwa mittels einer Isolierstoffolie 28 isolierte eine Stirnseite und in der anderen Materialausnehmung, etwa der Nut 27, die gegenüberliegende isolationsfreie Stirnseite der Abschirmelektrode 25 zu lagern.

Die Spule 14 ist nach Art einer Rogowskispule auf einen ringförmigen Kern 29 aus nichtferromagnetischem Material gewickelt. Der Kern 29 hat in axialer Richtung geschnitten im wesentlichen rechteckigen Querschnitt und ist im Vergleich zu seinem Radius sowie zu seiner axialen Erstreckung in radialer Richtung nur sehr gering bemessen. Bei einem Radius von beispielsweise 140 mm und einer axialen Längserstreckung von beispielsweise 100 mm weist er typischerweise eine Dicke von nur 5 mm auf. Hierdurch werden Unsymmetrien im Magnetfeld des zu messenden Stromes ausgeglichen und wird zugleich der Einfluss unerwünschter Fremdfelder minimiert. Der die Spule 14 aufnehmende Raum 19 ist mit einem ringförmigen Isolierkörper 30 ausgefüllt, durch den die Spule 14 am Tragkörper 13 fixiert ist.

Der Isolierkörper 30 fixiert zugleich die Abschirmelektrode 25 und trägt auf auf seiner inneren Mantelfläche die Messelektrode 15. Der Isolierkörper 30 und der Kern 29 der Spule 14 enthalten ein überwiegend isotropes Material. Hierdurch wird erreicht, dass sich Isolierkörper 30 und Kern 29 bei Temperaturänderungen in allen Richtungen gleichmässig dehnen bzw. zusammenziehen. Die Geometrie der Spule 14 und der Messelektrode 15 werden daher bei Temperaturveränderungen linear verändert. Diese Änderung kann durch eine ständige Temperaturüberwachung der Sensoren der Strom- und Spannungswandlers 10, 11 und eine aus dieser Überwachung resultierende ständige Anpassung der Auswerteelektronik leicht kompensiert werden.

Eine besonders hohe Messgenauigkeit lässt sich erreichen, wenn das Material des Isolierkörpers 30 und des Kerns 29 der Spule 14 einen an das Material der Abschirmelektroden 20, 21, 25 bzw, der Metallkapselung 4 angepassten Koeffizienten der Wärmeausdehnung aufweisen. Sehr bewährt als Material für den Isolierkörper 30 und/oder den Kern 29 hat sich eine mit Glaskügelchen gefüllte Vergussmasse, insbesondere auf der Basis eines Epoxidharzes. Als Material für den Kern 29 kann auch ein nichtferromagnetisches Metall verwendet werden. Insbesondere Aluminium ist hierfür besonders geeignet, da es bei hohen Frequenzen induzierte Spannungsspitzen stark dämpft, und da es zugleich einen dem im Isolierkörper 30 bzw. dem in der Metallkapselung 4 verwendeten Material entsprechenden Koeffizienten der Wärmeausdehnung aufweist.

Der Sensor der Strom- und Spannungswandler 10, 11 lässt sich in einfacher Weise durch Vergiessen vormontierter Teile mit einer nach Aushärtung zum Material des Isolierkörpers 30 führenden Vergussmasse fertigen. Bei der Fertigung wird zunächst in die horizontal gelagerte Abschirmelektrode 21 die vorgefertigte Spule 14 mittels isolierender Abstandshalter derart gelagert, dass sie die angestrebte Position einnimmt. Die Signalleitungen 16, 17 sind hierbei mittels nicht bezeichneter Durchführungen giessharzdicht durch die Abschirmelektrode 21 geführt. Die ringförmige, beispielsweise 3 mm dicke, Abschirmelektrode 25 wird mit einer ihrer beiden Stirnseiten in die Nut 27 geschoben und es wird eine in geringem Abstand zur und konzentrisch mit der Elektrode 25 die Messelektrode 15 angeordnet, deren Signalleitung 18 entsprechend den Signalleitungen 16 und 17 durch die Abschirmelektrode 21 geführt ist. Danach wird die Abschirmelektrode 20 auf die Abschirmelektrode 21 geführt und es wird in ihre Nut 26 die isolationsbehaftete Stirnseite der Abschirmelektrode 25 geschoben. Der so gebildete, die Spule 15 aufnehmende Raum 19 wird an der Stossfuge der beiden Abschirmelektroden 20, 21 sowie an den beiden zwischen der Messelektrode 15 und den Abschirmelektroden 20, 21 verbleibenden Isolationsabständen giessharzfest abgedichtet und nachfolgend über einen nicht dargestellten Zuführkanal mit einer härtbaren Vergussmasse, wie etwa einem Giessharz auf der Basis von Epoxid, gefüllt. Nach dem Aushärten der Vergussmasse ist dann der Sensor der Strom- und Spannungswandler 10, 11 fertiggstellt und kann nach geringfügiger Überarbeitung in die metallkapselte, gasisolierte Anlage eingebaut werden.

Die Spule 14 liefert ein der zeitlichen Änderung des im Stromleiter 5 fliessenden Stromes proportionales Signal, welches aufgrund der geeignet angeordneten Abschirmung frei von den Einflüssen unerwünschter Fremdfelder und von in der Anlage auftretenden, transienten Vorgängen ist und welches in der Auswerteelektronik zu einem dem zu ermittelndem Strom entsprechenden Signal integriert wird.

Die Messelektrode 15 dieses Sensors bildet nach dem Einbau in die Anlage mit dem Stromleiter 5 einen Koppelkondensator für das vom Stromleiter 5 ausgehende und der anliegenden Spannung entsprechende elektrische Feld und mit der Abschirmelektrode 24 einen die Verarbeitung und Genauigkeit des eingekoppelten Messignals verbessernden Hilfskondensator.

### BEZUGSZEICHENLISTE

- 1, 2: Schaltstellen
- 3: Antrieb
- 4: Metallkapselung
- 5: Stromleiter
- 6, 7, 8, 9: Kapselungsteile
- 10, 11: Strom- und Spannungswandler
- 12: Schrauben
- 13: Tragkörper
- 14: Spule
- 15: Messelektrode
- 16, 17, 18: Signalleitungen
- 19: Raum
- 20, 21: Abschirmelektroden
- 22, 23: Bohrungen
- 24: Ansatz
- 25: Abschirmelektrode
- 26, 27: Nuten
- 28: Isolierstoffolie
- 29: Kern
- 30: Isolierkörper

## Patentansprüche

1. Strom- und Spannungswandler (10, 11) für eine metallgekapselte, gasisolierte Hochspannungsanlage mit einem im Inneren der Metallkapselung (4) fixierbaren und der Halterung eines Strom- und eines Spannungssensors dienenden ringförmigen Tragkörper (13), bei dem der am Tragkörper (13) gehaltene Stromsensor als torusförmige Spule (14) auf einen ringförmigen Kern (29) gewickelt ist mit einem in axialer Richtung geschnitten im wesentlichen rechteckigem Querschnitt und mit einer im Vergleich zu seinem Radius und zu seiner axialen Erstreckung geringen radialen Bemessung, bei dem der am Tragkörper (13) gehaltene Spannungssensor als hohlzylindrische Messelektrode (15) ausgebildet ist, und bei dem nach Einbau in die Anlage Spule (14) und Messelektrode (15) einen Stromleiter (5) der Anlage konzentrisch umgeben, dadurch gekennzeichnet, dass die Spule (14) nach Art einer Rogowskispule auf einen Kern (29) aus nichtferromagnetischem Material gewickelt ist und in einem gegen elektrische Felder abgeschirmten, hohlzylindrisch ausgebildeten Raum (19) des Tragkörpers (13) angeordnet ist, dass eine als elektrische Abschirmung wirkende Begrenzungswand des Raums (19) nach dem Einbau des Wandlers auf das Potential der Metallkapselung (4) geführt ist, und dass der Raum (19) an seinen beiden Stirnseiten von zwei den Stromleiter (5) wulstförmig umgebenden Abschirmelektroden (20, 21) des Tragkörpers (13) begrenzt und mit einem die Spule (14) und die Messelektrode (15) fixierenden Isolierkörper (30) ausgefüllt ist.

2. Strom- und Spannungswandler nach Anspruch 1, dadurch gekennzeichnet, dass der Isolierkörper (30) und der Kern (29) der Spule (14) überwiegend isotropes Material enthalten.

3. Strom- und Spannungswandler nach Anspruch 2, dadurch gekennzeichnet, dass das Material des Isolierkörpers (30) und des Kerns (29) der Spule (14) einen an das Material der Metallkapselung (4) angepassten Koeffizienten der Wärmeausdehnung aufweisen.

4. Strom- und Spannungswandler nach einem der Ansprüche 2 oder 3, dadurch gekennzeichnet, dass zumindest der Kern (29) von einer mit kugelförmigen Teilchen gefüllten, ausgehärteten Vergussmasse aus Isoliermaterial gebildet ist.

5. Strom- und Spannungswandler nach einem der Ansprüche 2 oder 3, dadurch gekennzeichnet, dass der Kern (29) ein nichtferromagnetisches Metall enthält.

6. Strom- und Spannungswandler nach Anspruch 5, dadurch gekennzeichnet, dass das nichtferromagnetische Metall Aluminium ist.

7. Strom- und Spannungswandler nach einem der Ansprüche 1 bis 6, dadurch gekennzeichnet, dass neben den beiden Abschirmelektroden (20, 21) eine den Hohlraum (19) gegenüber dem Stromleiter (5) begrenzende dritte Abschirmelektrode (25) vorgesehen ist, deren eine Stirnseite in elektrisch leitender Weise an der ersten (21) und deren gegenüberliegende andere Stirnseite in elektrisch isolierender Weise an der zweiten (20) beider Abschirmelektroden (20, 21) gehalten ist.

8. Strom- und Spannungswandler nach Anspruch 7, dadurch gekennzeichnet, dass die Messelektrode (15) elektrisch isoliert und in geringem Abstand zur dritten Abschirmelektrode (25) ausserhalb des Raumes (19) angeordnet ist.

9. Strom- und Spannungswandler nach einem der Ansprüche 7 oder 8, dadurch gekennzeichnet, dass der die Spule (14) fixierende Isolierkörper (30) und die elektrische Isolation zwischen Messelektrode (15) und dritter Abschirmelektrode (25) von einer ausgehärteten Vergussmasse gebildet ist.

10. Strom- und Spannungswandler nach einem der Ansprüche 7 bis 9, dadurch gekennzeichnet, dass zumindest in der ersten (21) der beiden Abschirmelektroden (20, 21) eine den Stromleiter (5) umgebende Materialausnehmung zur Aufnahme einer der beide Stirnseiten der dritten Abschirmelektrode (25) eingelassen ist.

11. Strom- und Spannungswandler nach Anspruch 10, dadurch gekennzeichnet, dass in der ersten (21) und in zweiten Abschirmelektrode (20) jeweils eine Materialausnehmung eingelassen ist, von denen eine erste der Aufnahme einer isolationsfreien und eine zweite der Aufnahme einer isolationsbehafteten Stirnseite der dritten Abschirmelektrode (25) dient.

12. Strom- und Spannungswandler nach Anspruch 11, dadurch gekennzeichnet, dass die Materialausnehmungen jeweils als Nut (26, 27) ausgebildet sind, und jeweils einem von mindestens zwei montierbaren Teilen des Tragkörpers (13) zugeordnet sind.

## Claims

1. Current and voltage transformer (10, 11) for a metal-encapsulated, gas-insulated high-voltage installation having an annular supporting body (13) which can be fixed inside the metal encapsulation (4) and is used for holding a current sensor and a voltage sensor and in which the current sensor, held on the supporting body (13), is wound as a toroidal coil (14) on an annular core (29) having an essentially rectangular cross-section when cut in the axial direction and having a small radial dimension in comparison with its radius and with its axial extent, in which the voltage sensor, held on the supporting body (13), is constructed as a hollow-cylindrical measurement electrode (15) and in which, after fitment in the installation, the coil (14) and measurement electrode (15) concentrically surround a current conductor (5) of the installation, characterized in that the coil (14) is wound in the manner of a Rogowski coil on a core (29) of non-ferromagnetic material and is arranged in a hollow-cylindrical space (19) in the supporting body (13), which space is screened against electric fields, in that a boundary wall of the space (19), which provides the electrical screening, is connected, after installation of the transformer, to the potential of the metal encapsulation (4), and in that the space (19) is bounded at its two ends by two screening electrodes (20, 21) of the supporting body (13), which surround the current conductor (5) in the form of a torus, and is filled with an insulating body (30) which fixes the coil (14) and the measurement electrode (15).

2. Current and voltage transformer according to Claim 1, characterized in that the insulating body (30) and the core (29) of the coil (14) contain predominantly isotropic material.

3. Current and voltage transformer according to Claim 2, characterized in that the material of the insulating body (30) and of the core (29) of the coil (14) has a coefficient of thermal expansion matched to the material of the metal encapsulation (4).

4. Current and voltage transformer according to one of Claims 2 or 3, characterized in that at least the core (29) is formed by a cured casting compound of insulating material, filled with spherical particles.

5. Current and voltage transformer according to one of Claims 2 or 3, characterized in that the core (29) contains a non-ferromagnetic metal.

6. Current and voltage transformer according to Claim 5, characterized in that the non-ferromagnetic metal is aluminium.

7. Current and voltage transformer according to one of Claims 1 to 6, characterized in that in addition to the two screening electrodes (20, 21) a third screening electrode (25) is provided which bounds the hollow space (19) with respect to the current conductor (5) and whose one end face is held in an electrically conducting manner on the first (21), and whose other opposite end face on the second (20), of two screening electrodes (20, 21), in an electrically insulating manner.

8. Current and voltage transformer according to Claim 7, characterized in that the measurement electrode (15) is electrically insulated and is arranged outside the space (19), at a short distance from the third screening electrode (25).

9. Current and voltage transformer according to one of Claims 7 or 8, characterized in that the insulating body (30) fixing the coil (14) and the electrical insulation between the measurement electrode (15) and the third screening electrode (25) are formed from a cured casting compound.

10. Current and voltage transformer according to one of Claims 7 to 9, characterized in that a material recess, surrounding the current conductor (5), for holding one of the two end faces of the third screening electrode (25) is fitted at least into the first (21) of the two screening electrodes (20, 21).

11. Current and voltage transformer according to Claim 10, characterized in that a material recess is fitted into each of the first (21) and second (20) screening electrodes, of which recesses a first is used to hold an insulation-free end face of the third screening electrode (25) and a second is used to hold an insulated end face of the third screening electrode (25).

12. Current and voltage transformer according to Claim 11, characterized in that the material recesses are in each case constructed as a slot (26, 27) and are in each case allocated to one of at least two parts of the supporting body (13), which parts can be assembled.

## Revendications

1. Transformateur de courant et de tension (10, 11) pour une installation à haute tension à encapsulation métallique et à gaz isolant avec un corps de support annulaire (13) à fixer à l'intérieur de la capsule métallique (4) et servant de support pour un détecteur de courant et de tension, dans lequel le détecteur de courant supporté sur le corps de support (13) est enroulé en une bobine (14) en forme de tore sur un noyau annulaire (29), avec une section sensiblement rectangulaire en coupe en direction axiale et avec une dimension radiale petite par comparaison avec son rayon et avec sa longueur axiale, dans lequel le détecteur de tension supporté sur le corps de support (13) est constitué par une électrode de mesure (15) de forme cylindrique creuse, et dans lequel, après leur montage dans l'installation, la bobine (14) et l'électrode de mesure (15) entourent concentriquement un conducteur de courant (5) de l'installation, caractérisé en ce que la bobine (14) est enroulée à la manière d'une bobine de Rogowski sur un noyau (29) en matière non ferromagnétique et est disposée dans un espace (19) du corps de support (13) de forme cylindrique creuse, blindé contre les champs électriques, en ce qu'une paroi de limitation de l'espace (19) servant de blindage électrique est portée au potentiel de la capsule métallique (4) après le montage du transformateur, et en ce que l'espace (19) est limité à ses deux faces d'extrémité par deux électrodes de blindage (20, 21) du corps de support (13) qui entourent sous forme de bourrelets le conducteur de courant (5) et est rempli avec un corps isolant (30) fixant la bobine (14) et l'électrode de mesure (15).

2. Transformateur de courant et de tension suivant la revendication 1, caractérisé en ce que le corps isolant (30) et le noyau (29) de la bobine (14) contiennent principalement une matière isotrope.

3. Transformateur de courant et de tension suivant la revendication 2, caractérisé en ce que la matière du corps isolant (30) et du noyau (29) de la bobine (14) présente un coefficient de dilatation thermique adapté à la matière de la capsule métallique (4).

4. Transformateur de courant et de tension suivant l'une quelconque des revendications 2 ou 3, caractérisé en ce qu'au moins le noyau (29) est formé d'une masse de moulage durcie en matière isolante remplie de particules sphériques.

5. Transformateur de courant et de tension suivant l'une quelconque des revendications 2 ou 3, caractérisé en ce que le noyau (29) contient un métal non ferromagnétique.

6. Transformateur de courant et de tension suivant la revendication 5, caractérisé en ce que le métal non ferromagnétique est l'aluminium.

7. Transformateur de courant et de tension suivant l'une quelconque des revendications 1 à 6, caractérisé en ce qu'en plus des deux électrodes de blindage (20, 21), il est prévu une troisième électrode de blindage (25) délimitant l'espace creux (19) par rapport au conducteur de courant (5), dont une face d'extrémité est maintenue de façon électriquement conductrice contre la première (21) et dont l'autre face d'extrémité située à l'opposé est maintenue de façon électriquement isolante contre la seconde (20) des deux électrodes de blindage (20, 21).

8. Transformateur de courant et de tension suivant la revendication 7, caractérisé en ce que l'électrode de mesure (15) est disposée de façon électriquement isolée et à faible distance par rapport à la troisième électrode de blindage (25) à l'extérieur de l'espace (19).

9. Transformateur de courant et de tension suivant l'une quelconque des revendications 7 ou 8, caractérisé en ce que le corps isolant (30) fixant la bobine (14) et l'isolation électrique entre l'électrode de mesure (15) et la troisième électrode de blindage (25) sont formés d'une masse de moulage durcie.

10. Transformateur de courant et de tension suivant l'une quelconque des revendications 7 à 9, caractérisé en ce qu'au moins dans la première (21) des deux électrodes de blindage (20, 21) est ménagé un évidement de matière entourant le conducteur de courant (5) pour recevoir une des deux faces d'extrémité de la troisième électrode de blindage (25).

11. Transformateur de courant et de tension suivant la revendication 10, caractérisé en ce que dans la première (21) et dans la seconde (20) électrode de blindage est respectivement ménagé un évidement de matière, dont un premier sert au logement d'une face d'extrémité sans isolation et un second sert au logement d'une face d'extrémité isolée de la troisième électrode de blindage (25).

12. Transformateur de courant et de tension suivant la revendication 11, caractérisé en ce que les évidements de matière sont constitués par des rainures (26, 27), et sont respectivement associés à l'une d'au moins deux parties à monter du corps de support (13).
